Europäisches Patentamt

European Patent Office

Office européen des brevets

(11) Publication number: **0 061 345**
**B1**

(12) **EUROPEAN PATENT SPECIFICATION**

(45) Date of publication of patent specification: **22.02.89**   (51) Int. Cl.⁴: **G 06 F 11/10**

(21) Application number: **82301503.7**

(22) Date of filing: **23.03.82**

(54) **Processing circuits for operating on digital data words which are elements of a Galois field.**

(30) Priority: **23.03.81 JP 41921/81**

(43) Date of publication of application:
**29.09.82 Bulletin 82/39**

(45) Publication of the grant of the patent:
**22.02.89 Bulletin 89/08**

(84) Designated Contracting States:
**AT BE CH DE FR GB IT LI NL SE**

(56) References cited:
**EP-A-0 012 828**
**DE-A-2 657 408**
**US-A-4 030 067**
**US-A-4 099 160**
**US-A-4 107 652**
**US-A-4 142 174**

(73) Proprietor: **SONY CORPORATION**
**7-35 Kitashinagawa 6-Chome Shinagawa-ku**
**Tokyo 141 (JP)**

(72) Inventor: **Odaka, Kentaro**
**3245-1-307 Noborito Tama-ku**
**Kawasaki-shi Kanagawa-ken (JP)**

(74) Representative: **Thomas, Christopher Hugo**
**et al**
**D Young & Co 10 Staple Inn**
**London WC1V 7RD (GB)**

Courier Press, Leamington Spa, England.

**Description**

This invention relates to processing circuits for operating on digital data words which are elements of a Galois field. Such a circuit may be used, for example, where the elements of the Galois field GF($2^m$) are to be multiplied or divided for encoding or decoding a Bose-Chaudhuri-Hocquenghen (BCH) error correcting code or other similar code.

Many recently proposed systems for processing and recording a high fidelity audio signal first convert the audio signal to a digital signal, and then encode the digital signal as a pulse code modulated (PCM) signal for recording. The recorded PCM signal can be picked up and converted to a high fidelity analog signal without appreciable loss of quality.

In order to eliminate annoying crackle or popping that can occur when errors accompany the reproduced PCM signal, data words of the digital signal to be recorded are first encoded for error correction, for example, by a cross-interleaving technique, and error correction words are formed and accompany the cross-interleaved data words. Then, upon reproduction, any random errors can be corrected by generating syndromes formed by using the error-correction words, and any burst errors (for example, due to drop-out) can be spread over many words by means of the cross-interleaving technique, and can be effectively corrected or masked.

In a typical such error correction technique, a matrix-type error correction coding system is used, such as BCH coding or Reed-Solomon (RS) coding. These error correction coding systems are generally in the class of q-nary convolutional coding systems whose outputs can be considered as combinations of elements of a Galois field GF($2^m$). Accordingly, special operating circuits are required for operating on the data words as elements of a Galois field.

Currently, such operating circuits are constructed as complex arrays of logic gates. These circuits are generally quite irregular in design and require a vast number of special connections. Consequently, it is not practical to form an operating circuit as an integrated circuit (IC). Furthermore, even is such a circuit were integrated onto a semiconductor chip, the complexity of the circuit would require the surface area of the chip to be excessively large.

US patent specification US—A—4 142 174 discloses a processing circuit according to the precharacterizing part of claim 1, and EP—A—0 012 828 also discloses a similar processing circuit.

According to the present invention there is provided a processing circuit for operating on digital data words of a predetermined bit length m such that the digital data words form elements $\alpha^i$ of a Galois field ($2^m$) having an irreducible root $\alpha$, each said element corresponding to a power $\alpha^i$ of the irreducible root $\alpha$, the circuit comprising:

a conversion device to which said digital data words are applied in sequence as said elements and in response thereto providing corresponding exponents i thereof;

a modulo-($2^m-1$) adder; and

a reverse conversion device;

characterised by:

an input data bus for supplying said digital data words in time sequence to said conversion device;

a first register coupled to said conversion circuit for storing said exponents i;

a controlled inversion circuit following said first register and controlled by an inversion control signal so that said controlled inversion circuit provides, as an output thereof, said exponents i without inversion when said inversion control signal has one sense and with inversion when said inversion control signal has another, complementary sense;

said adder having first and second inputs and an output, with the output of said controlled inversion circuit being coupled to said first input thereof;

a second register having an input coupled to the output of said adder for storing the contents thereof and having an output;

a controlled gate circuit having an input coupled to the output of said second register and an output coupled to the second input of said adder and controlled by a gate control signal selectively to pass the contents of said second register to said adder; and

said reverse conversion device being coupled to the output of said second register to receive the contents thereof, and in response thereto to provide an output data word that is the power of said irreducible element corresponding to the contents of said second register.

The invention will now be described by way of example with reference to the accompanying drawings, in which:

Figures 1, 2, 3 and 4 are block diagrams of respective simple examples of circuits for embodiments of the invention; and

Figure 5 is a more detailed block diagram of an embodiment of circuit according to the invention.

To assist understanding of the following detailed description, the nature of a Galois field will first be explained briefly. The Galois field GF($p^m$) can be expressed either as a vector or a cyclical group.

The vector representation will be used first. In this representation, the Galois field GF($p^m$) is considered a polynomial ring with an irreducible polynomial F(x) of $m^{th}$ order on a Galois field GF(p) taken as modulus. Accordingly, if a root of F(x) is taken as $\alpha=\{x\}$, (where $\{x\}$ means a residue class), an element of GF($p^m$) can be expressed by a linear combination of:

$$\alpha=\{x\}, \quad \alpha^2=\{x^2\}, \ldots, \quad \alpha^{m-1}=\{x^{m-1}\}$$

In other words, an element of $GF(p^m)$ can be expressed as a polynomial:

$$a_{m-1}\{x^{m-1}\}+a_{m-2}\{x^{m-2}\}+ \ldots +a_1\{x\}+a_0=a_{m-1}\alpha^{m-1}+a_{m-2}\alpha^{m-2}+ \ldots +a_1\alpha+a_0$$

In short, it can be expressed using the vector representation as:

$$(a_{m-1}, a_{m-2}, \ldots, a_1, a_0)$$

where

$$a_{m-1}, a_{m-2}, \ldots, a_1, a_0 \equiv GF(p)$$

The Galois field $GF(p^m)$ will next be expressed by a cyclic group representation. The remaining element in which a zero element is excluded from $GF(p^m)$ forms a multiplicative group of order $p^m-1$. This multiplicative group is the cyclic group. In the multiplicative group G, when every element belonging to G are expressed by power multiplication of a certain element $\alpha$ of G, it is defined that G is termed the cyclic group and $\alpha$ is termed a primitive element.

For example, with respect to an irreducible polynomial $F(x)=x^3+x+1$ on $GF(2)$, a root $\alpha$ for establishing $F(x)=0$ is considered. The codes of the respective elements become the following based on

$$G(\alpha)=\alpha^3+\alpha+1=0 \quad (mod. \ \alpha^3+\alpha+1):$$

| power multiplication of $\alpha$ | | linear combination | | vector representation |
|---|---|---|---|---|
| — | = | 0 | = | 000 |
| $\alpha^0$ | = | 1 | = | 001 |
| $\alpha^1$ | = | $\alpha$ | = | 010 |
| $\alpha^2$ | = | $\alpha^2$ | = | 100 |
| $\alpha^3$ | = | $\alpha+1$ | = | 011 |
| $\alpha^4$ | = | $\alpha^2+\alpha$ | = | 110 |
| $\alpha^5$ | = | $\alpha^2+\alpha+1$ | = | 111 |
| $\alpha^6$ | = | $\alpha^2\alpha+1$ | = | 101 |

In this case, the power of $\alpha$ is a representation on the basis of the cyclic group.

For the error detecting and correcting code defined on $GF(2^m)$, we have previously proposed a code that it has high error correction capability against any one of burst and random errors. In addition, this code reduces the risk that error detection will be missed or erroneous correction will be done.

With this code, when m bits form one word and n words form one block, k check words are generated based on the following parity check matrix H:

$$H=\begin{bmatrix} 1 & 1 & \ldots 1 & 1 \\ \alpha^{n-1} & \alpha^{n-2} & \ldots \alpha & 1 \\ \alpha^{2(n-1)} & \alpha^{2(n-2)} & \ldots \alpha^2 & 1 \\ \cdot & \cdot & \cdot & \cdot \\ \cdot & \cdot & \cdot & \cdot \\ \cdot & \cdot & \cdot & \cdot \\ \alpha^{(k-1)(n-1)} & \alpha^{(k-1)(n-2)} & \ldots \alpha^{k-1} & 1 \end{bmatrix}$$

Moreover, if the case where four check words are used (k=4) is given as an example, the parity check matrix H becomes as follows:

$$H=\begin{bmatrix} 1 & 1 & \ldots 1 & 1 \\ \alpha^{n-1} & \alpha^{n-2} & \ldots \alpha & 1 \\ \alpha^{2(n-1)} & \alpha^{2(n-2)} & \ldots \alpha^2 & 1 \\ \alpha^{3(n-1)} & \alpha^{3(n-2)} & \ldots \alpha^3 & 1 \end{bmatrix}$$

3

Letting one block of the received data be represented as a column vector $V=(\hat{W}n-1, \hat{W}n-2, \ldots, \hat{W}1, \hat{W}0)$ (where $\hat{W}i=Wi+\varepsilon i$, $\varepsilon i$ being an error pattern), four syndromes $S_0$, $S_1$, $S_2$ and $S_3$ generated at the receiving side become as follows:

$$\begin{bmatrix} S_0 \\ S_1 \\ S_2 \\ S_3 \end{bmatrix} = H \cdot V^T$$

This error correction code can correct errors of up to two words within one error correction block, and if the error location is known, it can correct errors of up to three words or four words.

One block contains four check words ($p=W3$, $q=W2$, $r=W1$ and $S=W0$). These check words are obtained as follows:

$$\begin{bmatrix} p+q+r+s=\Sigma Wi=a \\ \alpha^3 p+\alpha^2 q+\alpha r+s=\Sigma\alpha^1 Wi=b \\ \alpha^6 p+\alpha^4 q+\alpha^2 r+s=\Sigma\alpha^{2l}Wi=c \\ \alpha^9 p+\alpha^6 q+\alpha^3 r+s=\Sigma\alpha^{3l}Wi=d \end{bmatrix}$$

where $\Sigma$ implies

$$\sum_{i=4}^{n-1} .$$

The calculation process is omitted but only the result is shown as follows:

$$\begin{bmatrix} p \\ q \\ r \\ s \end{bmatrix} = \begin{bmatrix} \alpha^{212} & \alpha^{153} & \alpha^{152} & \alpha^{209} \\ \alpha^{156} & \alpha^{2} & \alpha^{135} & \alpha^{152} \\ \alpha^{158} & \alpha^{138} & \alpha^{2} & \alpha^{153} \\ \alpha^{218} & \alpha^{158} & \alpha^{156} & \alpha^{212} \end{bmatrix} \begin{bmatrix} a \\ b \\ c \\ d \end{bmatrix}$$

The role of the encoder provided at the transmitting side is to form four check words p, q, r and s as described above.

An algorithm of the error correction where data including the check words formed as described above are transmitted and received will be described next. An equation with respect to syndromes in case of two erroneous words ($\varepsilon i$ and $\varepsilon j$) is:

$$\begin{bmatrix} S_0=\varepsilon i+\varepsilon j \\ \\ S_1=\alpha^i\varepsilon i+\alpha^j\varepsilon j \\ \\ S_2=\alpha^{2l}\varepsilon i+\alpha^{2j}\varepsilon j \\ \\ S_3=\alpha^{3l}\varepsilon^i+\alpha^{3j}\varepsilon j \end{bmatrix}$$

Transforming this equation:

$$(\alpha^i S_0+S_1)(\alpha^i S_2+S_3)=(\alpha^i S_1+S_2)^2$$

Further transforming this, the following error location polynomial is obtained:

$$(S_0 S_2+S_1^2)\alpha^{2i}+(S_1 S_2+S_0 S_3)\alpha^i+(S_1 S_3+S_2^2)=0$$

where coefficients of the respective equations are given as:

$$\begin{bmatrix} S_0 S_2+S_1^2=A \\ \\ S_1 S_2+S_0 S_3=B \\ \\ S_1 S_3+S_2^2=C \end{bmatrix}$$

4

By using the respective coefficients A, B and C of the above equations, it is possible to search for the error location in the case of two erroneous words.

(1) For no error:

$$A=B=C=0, \quad S_0=0 \text{ and } S_3=0$$

(2) For one word errors:

When $A=B=C=0$, $S_0 \neq 0$ and $S_3 \neq 0$, it is regarded as one word error. The error location i is known from $\alpha^i = S_1/S_0$, and the error is corrected by using $\varepsilon 1 = S_0$.

(3) For two word errors:

In case of an error of two words or more, $(A \neq 0, B \neq 0 \text{ and } C \neq 0)$ are established so that the discrimination or judgement of the error is greatly facilitated. At this time, is also established that:

$$A\alpha^{2i} + B\alpha^i + C = 0$$

(where $i=0$ to $(n-1)$).

In this case, if $(B/A=D$ and $C/A=E)$ is given:

$$D=\alpha^i+\alpha^j, \quad E=\alpha^i \cdot \alpha^j$$

and

$$\alpha^{2i}+D\alpha^i+E=0$$

Assuming that t is given as the difference between two error locations, that is, $(j=i+t)$, the above equation is modified to:

$$D=\alpha^i(1+\alpha^t), \quad E=\alpha^{2i+t}$$

thus:

$$D^2/E=\frac{(1+\alpha^t)^2}{\alpha^t}=\alpha^{-t}+\alpha^t$$

Accordingly, if the values of $\alpha^{-t}$ and $\alpha^t$ with respect to $t=1$ to $(n-1)$ are each written in a read only memory (ROM) beforehand and the coincidence between $(\alpha^{-t}+\alpha^t)$ obtained from the output of the ROM and the value $(D^2/E)$ calculated from the received word is detected, t can be obtained. If this coincidence relation is not established, it is regarded as an error of more than three words. To deal with the above, the following equations are given:

$$X=1+\alpha^t$$

$$Y=1+\alpha^{-t}=D^2/E+X$$

thus:

$$\alpha^i=D/X, \quad \alpha^j=D/Y$$

therefore the error locations i and j are obtained. Error patterns $\varepsilon i$ and $\varepsilon j$ are obtained as:

$$\varepsilon i=\frac{(\alpha^j S_0 + S_1)}{D}=S_0/Y+S_1 D$$

$$\varepsilon j=\frac{(\alpha^j S_0 + S_1)}{D}=S_0/X+S_1/D$$

Thus, the error correction can be performed.

With the aforesaid error detecting and correcting code, it is considered that one word is formed of eight bits (if one word is formed of sixteen bits, eight bits are obtained by dividing the sixteen bits into the more significant and the less significant eight bits). Then, $GF(2^8)$ is considered based on eight bits and the irreducible polynomial is represented as

$$F(x)=x^8+x^4+x^3+x^2+1,$$

which is the cyclic group of order 255.

In the encoding and decoding as set forth above, it is necessary to calculate the elements $\alpha^i$ and $\alpha^j$, as

5

well as products and quotients thereof. The embodiment to be described can be used for the multiplication and division in such calculations.

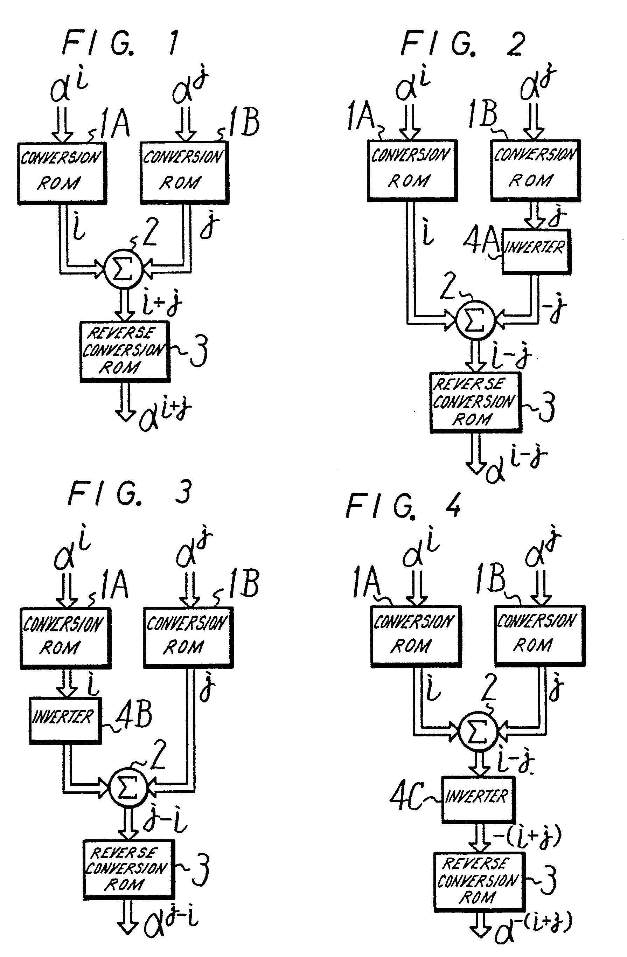

In the circuits of each of Figures 1 to 4, a conversion ROM 1A generates an index i when an element $\alpha^i$ is supplied thereto, and conversion ROM 1B generates an index j when it is supplied with an element $\alpha^j$. The indexes i and j are binary codes of m bits, respectively.

A modulo-$(2^m-1)$ adder 2 has inputs coupled to receive the indexes i and j and an output connected to a reverse conversion ROM 3. The reverse conversion ROM 3 produces a data output which is the product of the elements $\alpha^i$ and $\alpha^j$, or, generally, is a power of the irreducible root or primitive element, $\alpha$. The exponent of the data output is the sum (or difference) of the input indexes i and j.

In the above arrangement, programmable logic arrays (PLAs) or other equivalent devices can be used in place of the ROMs 1A, 1B and 3.

Figure 1 shows a circuit in which the indexes (or exponents) i and j are respectively generated in the conversion ROMs 1A and 1B, and are supplied to the adder 2. The adder 2 adds these indexes together so as to produce a sum output i+j, which is supplied to the reverse conversion ROM 3. The reverse conversion ROM 3 supplies a product output $\alpha^{i+j}=\alpha^i \cdot \alpha^j$ as its data output.

Figure 2 shows another circuit in which the index j generated from the conversion ROM 1B is supplied to and inverted by an inverter 4A and thence supplied to the adder 2. A difference output i−j is supplied from the adder 2 to the reverse conversion ROM 3; thus, a quotient output $(\alpha^{i-j}=\alpha^i/\alpha^j)$ is supplied as the data output.

Figure 3 shows a further circuit in which the index i produced from the conversion ROM 1A is supplied to and inverted by an inverter 4B and then supplied therefrom to the adder 2. A difference output j−i therefrom is supplied to the reverse conversion ROM 3, which provides a quotient output $(\alpha^{j-i}=\alpha^j/\alpha^i)$ as its data output.

Figure 4 shows a still further circuit in which the outputs from the conversion ROMs 1A and 1B are supplied to the adder 2 so that a sum output i+j therefrom is supplied to and inverted by an inverter 4C. The inverted sum output (i+j) is then supplied to the reverse conversion ROM 3 which supplies an inverted output $\alpha^{-(i+j)}=1/\alpha^{i+j}$ as its data output.

A single circuit arrangement including all three inverters 4A, 4B and 4C can be arranged to perform either an inverting or a non-inverting operation in dependence on an external control signal. This permits multiplication or division to be switched in response to the control signal.

In the case of a one erroneous word, where the error detecting and correcting code is decoded as described previously, it is necessary that $\alpha^i=S_1/S_0$ be calculated so that the error location can be determined from $\alpha^i$. However, if the dividing circuit (Figure 2 or 3) is used, the error location i can be obtained from the adder 2 directly.

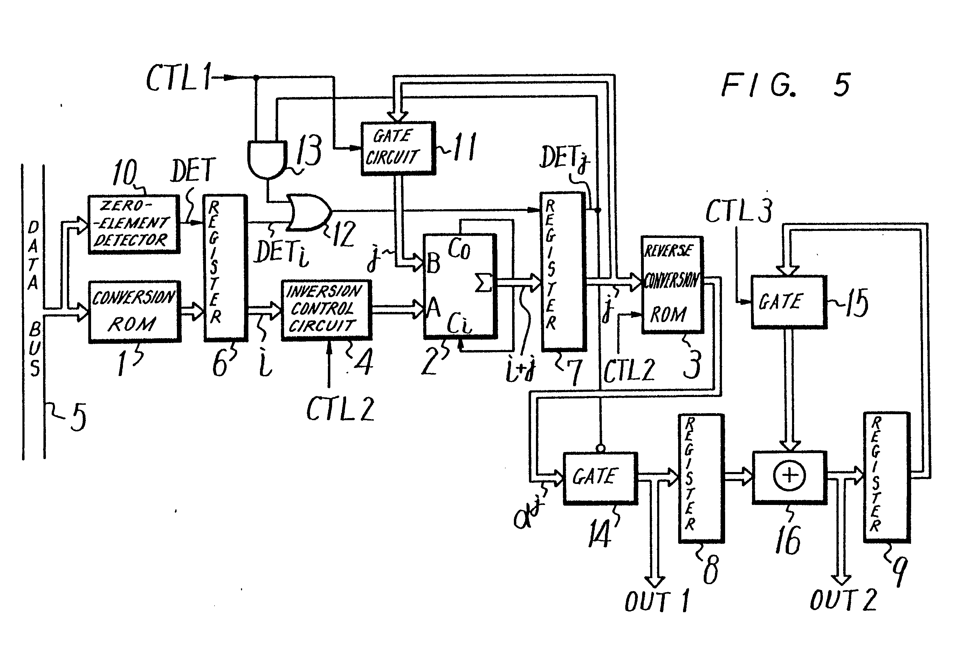

A more detailed embodiment will now be described with reference to Figure 5.

In this embodiment, an inversion control circuit or controller 4 is provided switchably to change over its inverting and non-inverting operation in accordance with a control signal $CTL_2$. For example, the inversion control circuit 4 is arranged for inversion and non-inversion if the control signal $CTL_2$ is "1" and "0", respectively. The inversion control circuit 4 enables either the multiplication or division to be carried out and also permits a time-sharing process to be adopted to reduce the number of the required conversion ROMs to one.

In Figure 5, a data bus 5 supplies data words to a single conversion ROM 1. The conversion ROM converts each incoming data word, as an element $\alpha^i$ to the associated index i, and the index i is stored in a data register 6.

Incoming data words are also supplied from the data bus 5 to a zero element detector 10. The zero element detector 10 produces a single-bit detecting signal DET of "1" when the input data word is the zero element, and of "0" when the input data word is not the zero element. This detecting signal DET is stored in the data register 6 together with the index data (for example, eight bits) derived from the conversion ROM 1. The data stored in the data register 6 are supplied through the inversion control circuit 4 to a modulo-$(2^m-1)$ adder 2 as an input A thereto. Here, m=8 and the adder 2 is a modulo-255 adder. As another input B of the adder 2, data, stored in a subsequent data register 7 located at the next stage and passed through a gate circuit 11, are used.

The gate circuit 11 is controlled by a control signal $CTL_1$. When the control signal $CTL_1$ is "1", the gate circuit 11 passes the data derived from the data register 7 therethrough and supplies it to the adder 2 as the input B, thus resulting in a sum output A+B. When the control signal $CTL_1$ is "0", the gate circuit 11 blocks data from passing therethrough and instead makes its output data zero so that the output is simply A. In other words, the input data, unchanged, are supplied from the adder 2 to the data register 7.

Also, the detecting signal $DET_i$ associated with the data word element $\alpha^i$ is supplied from the data register 6 through an OR gate 12 to the data register 7. The detecting signal $DET_j$ previously stored in the data register 7 and associated with a previous data word element $\alpha^j$ is supplied through an AND gate 13 to the OR gate 12. The control signal $CTL_1$ is used as another input of this AND gate 13, so that when $CTL_1$ is "1" the output from the OR gate 12 is "1" even in the case where the detecting signal $DET_j$ stored in the register 7 is "0".

The modulo-255 adder 2 can comprise an 8-bit full adder in which the carry output $D_0$ is positively fed

back to the carry input $C_i$. Depending on the value of the adder output, the adder 2 operates as follows, where $\Sigma$ is the contents of the adder 2:

| | | | |
|---|---|---|---|
| $0 \le A+B \le 254$ | | $\Sigma = A+B$ | $C_0 = 0$ |
| $A+B = 255$ | | $\Sigma = 255$ | $C_0 = 0$ |
| $A+B = 256$ | after | $\Sigma = 0$ | and $C_0 = 1,$ |
| | | $\Sigma = 1$ | and $C_0 = 1$ |
| $256 < A+B \le 510$ | | $\Sigma = A+B-255$ | and $C_0 = 1$ |

Then, the added output data stored in the data register 7 is supplied to the reverse conversion ROM 3 which produces the data element $\alpha^{i+j}$ in which this added output $\Sigma$ is taken as the index, or exponent. The reverse conversion ROM 3 is supplied with the control signal $CTL_2$, which is also supplied to the inversion control circuit 4 to switch the multiplication and the division functions alternately. The data output from the reverse conversions ROM 3 is presented as an output OUT 1 by way of a gate circuit 14, and is also supplied to an element storage register 8. When the detecting signal DET stored in the data register 7 is "1", the gate circuit 14 causes the data output of the gate circuit 14 to be zero.

In this embodiment, modulo-2 added outputs of two data elements $\alpha^i$ and $\alpha^j$ are further produced as an output OUT 2, and this is stored in another element storage register 9. The output data stored in the element storage register 9 are passed through a gate circuit 15 and are supplied to a modulo-2 adder 16 together with the output data from the data register 8, so as to produce the data output OUT 2. The gate circuit 15 is controlled by a control signal $CTL_3$ to pass the data stored in the element storage register 9 therethrough and supplies it to the adder 16 only when required to obtain the modulo-2 output OUT 2.

In this embodiment, when the multiplication operation is performed, the control signal $CTL_2$, which can be supplied from a microprocessor (not shown) to the inversion control circuit 4, becomes "0" to control it to perform the non-inversion operation.

More specifically, at first, the 8-bit data element $\alpha^j$ is supplied through the data bus 5. Next, the 8-bit element data $\alpha^i$ passes therethrough in the same manner. Accordingly, the data element $\alpha^i$ is supplied to the conversion ROM 1 and the index data i and the associated detecting signal $DET_i$ are stored in the data register 6. At such time, the data register 7 stores the index data j and the detecting signal $DET_j$ of the data element $\alpha^j$.

Thereafter, when the control signal $CTL_1$ becomes "1", the sum (i+j) of the index data i and j is formed by the adder 2. Further, in the next step, this sum (i+j) and the output from the OR gate 12 are fed to and stored in the data register 7. The reverse conversion ROM 3 produces an output $\alpha^{i+j}$ based on the sum output (i+j). When neither of two input data elements $\alpha^i$ and $\alpha^j$ is the zero element, the output data $\alpha^{i+j}$ of the reverse conversion ROM 3 appear as the output OUT 1. On the other hand, when either one of the data elements $\alpha^i$ and $\alpha^j$ is the zero element, the reverse conversion ROM produces either the output data element $\alpha^i$ or $\alpha^j$. However, the output data element so produced is converted to the zero element in response to the detecting signal supplied to the gate circuit 14.

When a division operation is to be performed, the control signal $CTL_2$ becomes "1", and the index data generated from the conversion ROM 1 are passed through the inversion control circuit 4 so as to invert such data. In other words, the quotient $\alpha^j/\alpha^i$ means that an inverse element $\alpha^{-i}$ is multiplied by $\alpha^j$ and this inverse element $\alpha^{-i}$ satisfies the relation $\alpha^i \cdot \alpha^{-i} = \alpha^0 = 1$. The inverse index $-i$ is a complement for the index i with respect to unity. In this embodiment, the bits of the index are inverted between "0" and "1", that is to the complementary bits "1" and "0". Therefore, the other processes aside from the above are the same as those of the multiplication operations as described before. Of course, in the inversion control circuit 4, if j is inverted to $-j$, the divided output, or quotient of $\alpha^i/\alpha^j$ can be calculated.

In a division operation, the result of any operation involving the zero element has no real significance. In other words, quotients $\alpha^i/0$ and 0/0 cannot be defined. In this embodiment, it is detected whether the zero element is received from the data bus 5, and if the zero element is so detected, the calculated output is forcibly converted to the zero element by the gate circuit 14. The divided output is never the zero element, so that if the zero element appears in the output, it is considered as abnormal. Accordingly, the next circuit to which the divided output is supplied performs a predetermined operation confirming that the divided output is not the zero element.

As it will be understood from the above description that, unlike the previously proposed circuits for operating on digital data as elements of a Galois field, in which many gate circuits are combined, embodiments of the invention can be simply constructed by the ROMs, the adders, and the registers as shown, thus achieving a relatively simple circuit suitable for integration onto a semiconductor chip.

Also, in the Figure 5 embodiment, because a time-sharing process is used, only one conversion ROM 1 and only a single reverse conversion ROM 3 are required, thereby further simplifying the circuit.

# EP 0 061 345 B1

**Claims**

1. A processing circuit for operating on digital data words of a predetermined bit length m such that the digital data words form elements $a^i$ of a Galois field ($2^m$) having an irreducible root a, each said element corresponding to a power $a^i$ of the irreducible root a, the circuit comprising:

a conversion device (1) to which said digital data words are applied in sequence as said elements and in response thereto providing corresponding exponents i thereof;

a modulo-($2^m-1$) adder (2); and

a reverse conversion device (3);

characterised by:

an input data bus (5) for supplying said digital data words in time sequence to said conversion device (1);

a first register (6) coupled to said conversion circuit (1) for storing said exponents i;

a controlled inversion circuit (4) following said first register (6) and controlled by an inversion control signal so that said controlled inversion circuit (4) provides, as an output thereof, said exponents i without inversion when said inversion control signal has one sense and with inversion when said inversion control signal has another, complementary sense;

said adder (2) having first and second inputs and an output, with the output of said controlled inversion circuit (4) being coupled to said first input thereof;

a second register (7) having an input coupled to the output of said adder (2) for storing the contents thereof and having an output;

a controlled gate circuit (11) having an input coupled to the output of said second register (7) and an output coupled to the second input of said adder (2) and controlled by a gate control signal selectively to pass the contents of said second register (7) to said adder (2); and

said reverse conversion device (3) being coupled to the output of said second register (7) to receive the contents thereof, and in response thereto to provide an output data word that is the power of said irreducible element corresponding to the contents of said second register (7).

2. A circuit according to claim 1 further comprising a zero element detector (10) coupled to said data bus (5) and supplying to said first register (6) a detecting signal of one sense to indicate that an associated one of the input data words is zero but of another, complementary sense otherwise;

logic gate means (12, 13) supplying the detecting signal stored in said first register (6) to said second register (7); and

an output gate (14) having a control input controlled by the detecting signal stored in said second register (7) and a data input coupled to said reverse conversion device (3) for passing the output of said reverse conversion device (3) when said detecting signal stored in said second register (7) has said other sense and blocking said output when said detecting signal has said one sense.

3. A circuit according to claim 2 wherein said logic gate means (12, 13) includes an AND gate (13) having inputs to receive the detecting signal stored in said second register (7) and said gate control signal, respectively, and an output; and

an OR gate (12) having inputs coupled to the output of said AND gate (13) and to said first register (6) to receive the detecting signal stored therein, respectively, and an output coupled to said second register (7).

4. A circuit according to claim 1, claim 2 or claim 3 further comprising means (10) providing a detecting signal if one of said input elements $a^i$ is a zero element, and means (14) for converting the output data element to a predetermined value in response to said detecting signal, such that any quotient resulting from division by zero is compensated.

5. A circuit according to any one of the preceding claims wherein said bit length m is eight bits and said adder 2 is a modulo-255 adder.

**Patentansprüche**

1. Verarbeitungs-Schaltung zum Verarbeiten digitaler Datenwörter einer vorbestimmten Bitlänge m derart, daß die digitalen Datenwörter Elemente $a^i$ eines Galois-Feldes ($2^m$) bilden, das eine unzerlegbare Wurzel a aufweist, wobei jedes Element einer Potenz $a^i$ der unzerlegbaren Wurzel a entspricht und wobei die Schaltung umfaßt:

— eine Umsetzeinrichtung (1), der die digitalen Datenwörter aufeinanderfolgend als die Elemente zugeführt werden und die in Reaktion darauf diesen entsprechende Exponenten i bestimmt,

— einen Modulo-($2^m-1$)-Addierer (2) und

— eine Umkehrumsetzeinrichtung (3), gekennzeichnet durch

— einen Eingangsdatenbus (5) zum Zuführen der digitalen Datenwörter in zeitlicher Aufeinanderfolge zu der Umsetzeinrichtung (1),

— ein erstes Register (6), das mit der Umsetzeinrichtung (1) verbunden ist, zum Speichern der Exponenten i,

— eine gesteuerte Inversionsschaltung (4), die auf das erste Register (6) folgt und durch ein Inversionsteuersignal gesteuert wird, so daß die gesteuerte Inversionsschaltung (4) als ihr Ausgangssignal

8

die Exponenten i ohne Inversion erzeugt, wenn das Inversionssteuersignal einen Wert hat, und mit Inversion erzeugt, wenn das Inversionssteuersignal einen anderen, komplementären Wert hat,

— wobei der Addierer (2) einen ersten und einen zweiten Eingang sowie einen Ausgang hat und wobei der Ausgang der gesteuerten Inversionsschaltung (4) mit dem ersten Eingang des Addierers verbunden ist,

— ein zweites Register (7), das einen Eingang, der mit dem Ausgang des Addierers (2) zum Speichern der Inhalte desselben verbunden ist, und einen Ausgang hat,

— eine gesteuerte Gatterschaltung (11), die einen Eingang, der mit dem Ausgang des zweiten Registers (7) verbunden ist, und einen Ausgang hat, der mit dem zweiten Eingang des Addierers (2) verbunden ist, und die durch ein Gattersteuersignal selektiv gesteuert wird, um die Inhalte des zweiten Registers (7) zu dem Addierer (2) durchzuschalten, wobei die Umkehrumsetzeinrichtung (3) mit dem Ausgang des zweiten Registers (7) verbunden ist, um dessen Inhalte aufzunehmen und in Reaktion darauf ein Ausgangsdatenwort zu erzeugen, das die Potenz des unzerlegbaren Elements entsprechend den Inhalten des zweiten Registers (7) ist.

2. Schaltung nach Anspruch 1, die desweiteren umfaßt:

— einen Nullelementdetektor (10), der mit dem Datenbus (5) verbunden ist und dem ersten Register (6) ein Erfassungssignal eines Werts zuführt, um anzugeben, daß ein zugeordnetes der Eingangsdatenwörter Null ist, jedoch andererseits ein Erfassungssignal eines anderen komplementären Werts zuführt,

— eine Logikgatterschaltung (12, 13), die das Erfassungssignal, das in dem ersten Register (6) gespeichert ist, dem zweiten Register (7) zuführt, und

— ein Ausgangsgatter (14), das einen Steuereingang, der durch das Erfassungssignal gesteuert wird, das in dem zweiten Register gespeichert ist, und einen Datenausgang hat, der mit der Umkehrumsetzeinrichtung (3) verbunden ist zum Durchschalten des Ausgangssignals der Umkehrumsetzeinrichtung (3), wenn das Erfassungssignal, das in dem zweiten Register (7) gespeichert ist, den anderen Wert hat, und zum Sperren des Ausgangssignals, wenn das Erfassungssignal den einen Wert hat.

3. Schaltung nach Anspruch 2, bei der die Logikgatterschaltung (12, 13) enthält:

— ein UND-Glied (13), das Eingänge zum Aufnehmen des Erfassungssignals, welches in dem zweiten Register (7) gespeichert ist, bzw. des Gattersteuersignals sowie einen Ausgang hat, und

— ein ODER-Glied (12), das Eingänge, die mit dem Ausgang des UND-Glieds (13) bzw. dem ersten Register (6) zum Aufnehmen des Erfassungssignals, das darin gespeichert ist, sowie einen Ausgang hat, der mit dem zweiten Register (7) verbunden ist.

4. Schaltung nach Anspruch 1, 2 oder 3, die desweiteren ein Mittel (10), das ein Erfassungssignal erzeugt, wenn eines der Eingangselement $\alpha^i$ ein Nullelement ist, und ein Mittel (14) umfaßt zum Umsetzen der Ausgangsdaten des Ausgangsdatenelements in einen vorbestimmten Wert in Reaktion auf das Erfassungssignal derart, daß ein Quotient, der sich aus der Teilung durch Null ergibt, kompensiert wird.

5. Schaltung nach einem der vorhergehenden Ansprüche, bei der die Bitlänge m 8 Bit beträgt und der Addierer (2) ein Modulo-255-Addierer ist.

**Revendications**

1. Circuit de traitement pour exploiter des mots de données numériques d'une longueur m en bits prédéterminée telle que les mots de données numériques constituent des éléments $\alpha^i$ d'un domaine de Galois $(2^m)$ ayant une racine non réductible $\alpha$, chaque élément correspondant à une puissance $\alpha^i$ de la racine non réductible $\alpha$, le circuit comprenant:

un dispositif de conversion (1) auquel les mots de données numériques sont appliqués séquentiellement comme les éléments et, en réponse à ceux-ci, fournissant leurs exposants i correspondants;

un additionneur en modulo-$(2^m-1)$ (2); et

un dispositif de conversion inverse (3);

caractérisé par:

un bus de données d'entrée (5) pour fournir les mots de données numériques séquentiellement dans le temps au dispositif de conversion (1);

un premier registre (6) couplé au circuit de conversion (1) pour mémoriser les exposants i;

un circuit d'inversion commandé (4) suivant le premier registre (6) et commandé par un signal de commande d'inversion de sorte que le circuit d'inversion commandé (4) fournit, comme signal de sortie de celui-ci, les exposants i sans inversion quand le signal de commande d'inversion a un sens et avec inversion quand le signal de commande d'inversion a un autre sens complémentaire;

l'additionneur (2) comportant des première et deuxième entrées et une sortie, la sortie du circuit d'inversion commandée (4) étant couplée à sa première entrée;

un deuxième registre (7) comportant une entrée couplée à la sortie de l'additionneur (2) pour mémoriser son contenu et comportant une sortie;

un circuit à porte commandé (11) comportant une entrée couplée à la sortie du deuxième registre (7) et une sortie couplée à la deuxième entrée de l'additionneur (2) et commandé par un signal de commande de porte pour transférer sélectivement le contenu du deuxième registre (7) jusqu'à l'additionneur (2); et

le dispositif de conversion inverse (3) étant couplé à la sortie du deuxième registre (7) pour recevoir son contenu, et, en réponse à celui-ci, pour fournir un mot de données de sortie qui est la puissance de l'élément non réductible correspondant au contenu du deuxième registre (7).

2. Circuit selon la revendication 1, comprenant en outre un détecteur d'élément nul (10) couplé au bus de données (5) et fournissant au premier registre (6) un signal de détection d'un sens pour indiquer qu'un mot associé parmi les mots de données d'entrée est nul mais d'un autre sens complémentaire autrement;

un moyen à portes logiques (12, 13) fournissant le signal de détection mémorisé dans le premier registre (6) au deuxième registre (7); et

une porte de sortie (14) comportant une entrée de commande commandée par le signal de détection mémorisé dans le deuxième registre (7) et une entrée de données couplée au dispositif de conversion inverse (3) pour laisser passer les données de sortie du dispositif de conversion inverse (3) quand le signal de détection mémorisé dans le deuxième registre (7) a l'autre sens et bloquant les données de sortie quand le signal de détection a ledit sens.

3. Circuit selon la revendication 2, dans lequel le moyen à portes logiques (12, 13) comprend une porte ET (13) comportant des entrées pour recevoir le signal de détection mémorisé dans le deuxième registre (7) et le signal de commande de porte, respectivement, et une sortie; et

une porte OU (12) comportant des entrées couplées à la sortie de la porte ET (13) et au premier registre (6) pour recevoir le signal de détection qui y est mémorisé, respectivement, et une sortie couplée au deuxième registre (7).

4. Circuit selon l'une quelconque des revendications 1 à 3, comprenant en outre un moyen (10) fournissant un signal de détection si un des éléments d'entrée $\alpha^i$ est un élément nul, et un moyen (14) pour convertir l'élément de données de sortie en une valeur prédéterminée en réponse au signal de détection, de sorte que tout quotient résultant d'une division par zéro est compensé.

5. Circuit selon l'une quelconque des revendications 1 à 4, dans lequel la longueur m en bits est égale à huit bits et l'additionneur 2 est un additionneur en modulo-255.

FIG. 1

FIG. 2

FIG. 3

FIG. 4

FIG. 5

CTL1

GATE CIRCUIT ~11

DET

ZERO- ELEMENT DETECTOR 10

REGISTER 6

$DET_i$

13

12

$DET_j$

CTL3

GATE ~15

CONVERSION ROM 1

INVERSION CONTROL CIRCUIT 4

B    $C_0$
A    $C_i$

2

REGISTER 7

REVERSE CONVERSION ROM 3

DATA BUS 5

CTL2

$i$

$i+j$

$j$

CTL2

$j$

$d_j$

GATE 14

REGISTER 8

$\oplus$ 16

REGISTER 9

OUT 1

OUT 2

EP 0 061 345 B1

2